(19) Europäisches Patentamt / European Patent Office / Office européen des brevets

(11) **EP 1 926 215 B1**

(12) **EUROPEAN PATENT SPECIFICATION**

(45) Date of publication and mention of the grant of the patent:
**27.05.2009 Bulletin 2009/22**

(51) Int Cl.:
**H03M 13/27** (2006.01)   H03M 13/29 (2006.01)

(21) Application number: **06024548.7**

(22) Date of filing: **27.11.2006**

(54) **Parallel concatenated zigzag codes with UMTS turbo interleavers**

Parallel verkettete ZigZag-Kodes mit UMTS Turbo-Interleavern

Codes zigzag concaténés en parallèle avec des entrelaceurs turbo UMTS

(84) Designated Contracting States:
**DE GB**

(43) Date of publication of application:
**28.05.2008 Bulletin 2008/22**

(73) Proprietor: **NTT DoCoMo, Inc.**
**Chiyoda-ku**
**Tokyo 100-6150 (JP)**

(72) Inventors:
 • **Bauch, Gerhard**
  **80799 Munich (DE)**
 • **Kusume, Katsutoshi**
  **80634 Munich (DE)**

(74) Representative: **Zinkler, Franz et al**
**Schoppe, Zimmermann, Stöckeler & Zinkler**
**Patentanwälte**
**Postfach 246**
**82043 Pullach bei München (DE)**

(56) References cited:
 **EP-A2- 1 441 448**     **US-A1- 2006 015 789**

 • **NEFEDOV ET AL: "MULTI-DIMENSIONAL ZIGZAG CODES FOR HIGH DATA RATE TRANSMISSION" INTERNATIONAL SYMPOSIUM ON TURBO CODES AND RELATED TOPICS, XX, XX, 2003, pages 215-218, XP009078361**
 • **WEI ZHANG ET AL: "On the design of high rate multiple turbo codes" PROC. 2006 IEEE INTERNATIONAL SYMPOSIUM ON INFORMATION THEORY, 9 July 2006 (2006-07-09), - 14 July 2006 (2006-07-14) pages 2564-2568, XP002418730 Seattle, USA ISBN: 1-4244-0504-1**
 • **BARBULESCU A S ET AL: "Interleaver design for three dimensional turbo codes" PROC. INTERNATIONAL SYMPOSIUM ON INFORMATION THEORY 1995, 17 September 1995 (1995-09-17), page 37, XP010192487 Whistler, Canada ISBN: 0-7803-2453-6**
 • **K. KASUME, G. BAUCH: "Some Aspects of Interleave Division Multiple Access in Ad Hoc Networks" PROC. 4TH INTERNATIONAL SYMPOSIUM ON TURBO CODES AND RELATED TOPICS, [CD-ROM] 3 April 2006 (2006-04-03), - 7 April 2006 (2006-04-07) pages 1-6, XP002418731 Munich, Germany**
 • **HE C ET AL: "JOINT INTERLEAVER DESIGN FOR LOW COMPLEXITY MULTIPLE TURBO CODES" INTERNET CITATION, [Online] XP002314198 Retrieved from the Internet: URL:http://tait.e-technik.uni-ulm.de~huebn er/ publications/itw.huebner.2003.p> [retrieved on 2005-01-19]**

EP 1 926 215 B1

**Description**

The present invention relates to the field of communication networks, as for example WCDMA (Wideband Code Division Multiple Access) and OFDMA (Orthogonal Frequency Division Multiple Access) based networks as specified by the international standardization bodies, where zigzag codes and concatenated zigzag codes are under consideration for enhancements of present communication systems, like UMTS, and candidates for introduction in future communication systems as LTE for error control coding.

Concatenated zigzag codes are attractive coding schemes since they offer excellent performance while having relatively low encoding and decoding complexity. Powerful codes are obtained by parallel concatenation of several constituent zigzag codes, which encode interleaved versions of the data sequence. This implies a new problem in interleaver design: Not only one interleaver, which is optimized for iterative decoding is needed, but several interleavers are needed. Each of those interleavers should provide good performance of iterative decoding while the interleavers should be mutually as independent as possible.

Zigzag codes have been proposed in L. Ping, X. Huang, and N. Phamdo, "Zigzag codes and concatenated zigzag codes," IEEE Transactions on Information Theory, vol. 47, pp. 800-807, February 2001, and extended in S.-N. Hong and D.-J. Shin, "Construction and analysis of rate compatible punctured concatenated zigzag codes," in International Symposium on Information Theory (ISIT), pp. 840-844, IEEE, September 2005, S.-N. Hong and D.-J. Shin, "Optimal rate-compatible punctured concatenated zigzag codes," in International Conference on Communications (ICC), pp. 627-631, IEEE, May 2005, S.-N. Hong and D.-J. Shin, "Design of irregular concatenated zigzag codes," in International Symposium on Information Theory (ISIT), pp. 1363-1366, IEEE, September 2005, L. Ping, S. Chan, and K. Yeung, "Iterative decoding of multidimensional concatenated single parity check codes," in International Conference on Communications (ICC), pp. 131-135, IEEE, June 1998, X. Wu, Y. Xue, and H. Xiang, "On concatenated zigzag codes and their decoding schemes," IEEE Communications Letters, vol. 8, pp. 54-56, January 2004, N. Nefedov, "Multi-dimensional zigzag codes for high data rate transmission," in 3rd International Symposium on Turbo Codes and Related Topics, pp. 215-218, September 2003, N. Nefedov, data rate transmission," in 14th International Symposium on Personal, Indoor and Mobile Radio Communications, pp. 1868-1872, September 2003.

They are attractive because of their low encoding and decoding complexity and their excellent performance particularly with high code rates. Concatenated zigzag codes with iterative decoding perform only about 0.5 dB worse than parallel-concatenated convolutional codes (turbo codes) while having significantly lower complexity. A single zigzag code is a very weak code due to its small minimum Hamming distance of $d_{min} = 2$. Strong codes are obtained by concatenation of zigzag codes where each constituent code encodes an interleaved version of the data sequence. Since a zigzag code has usually relatively high rate, multiple zigzag codes have to be concatenated in order to obtain codes with reasonable rate and error correction capabilities. Building low rate codes by concatenation of several constituent codes is a difference to turbo codes, where usually only two constituent codes are concatenated.

This implies a new problem in interleaver design: Not only one interleaver, which is optimized for iterative decoding is needed but several interleavers are needed. Each of those interleavers should provide good performance of iterative decoding while the interleavers should be mutually as independent as possible. It is still an open problem what is a good criterion for mutual independency of multiple interleavers. At the same time, the interleavers shall introduce randomness such that the extrinsic information of the constituent decoders becomes approximately uncorrelated.

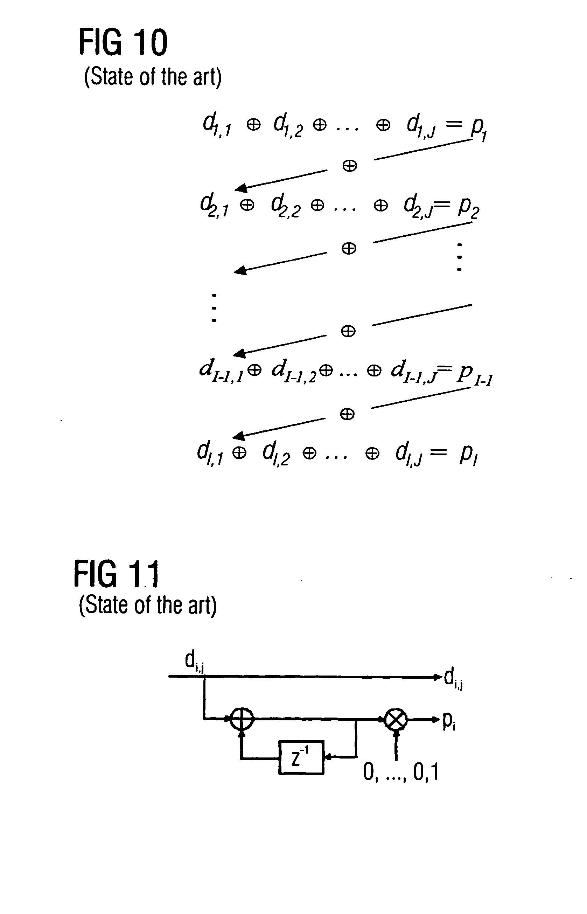

Zigzag codes are attractive because of their low encoding and decoding complexity and their excellent performance particularly with high code rate. Concatenated zigzag codes perform only about 0.5 dB worse than parallel-concatenated convolutional codes (turbo codes) while having significantly lower complexity. The principle of regular zigzag codes is illustrated in Fig. 10, where $\oplus$ denotes the modulo 2 sum. The data bits $d_{ij} \in (0, 1)$ are arranged in an $I \times J$ matrix. Each row of the matrix is called a segment of the zigzag code. The parity bits $p_i$ are determined as the modulo 2 sum over each segment $i$ including the previous parity bit $p_{i-1}$. The zigzag code is completely described by the two parameters $I$ and $J$.

An equivalent encoder for a zigzag code is a punctured recursive convolutional encoder with memory 1 as depicted in Fig. 11. The puncturing pattern for the parity bits is chosen such that only every $J$-th parity bit of the trellis encoder is transmitted. A single zigzag code has weak performance since the minimum Hamming distance is $d_{min} = 2$. This is easily verified when two data bits within a segment $i$ are flipped.

In this case, the parity bit $p_i$ will remain unchanged and consequently no other bits in the codeword are affected. A codeword with minimum Hamming weight $w_H = d_{min} = 2$ occurs, if the data sequence contains only two bits with value $d_{ij} = 1$ which are located within the same segment as depicted in Fig. 12. Low weight codewords with Hamming weight $w_H = 3$ are generated if a single bit with value 1 appears in two consecutive segments as shown in Fig. 13. In order to build a powerful code, several constituent zigzag codes have to be concatenated. Each of the respective constituent encoders encodes an interleaved sequence of the data bits as shown in Fig. 14, where $\Pi_k$ indicates the permutation rule of interleaver $k$. Since the code rate $R_c = J/(J+1)$ of a zigzag code is usually relatively high, several zigzag codes need to be concatenated.

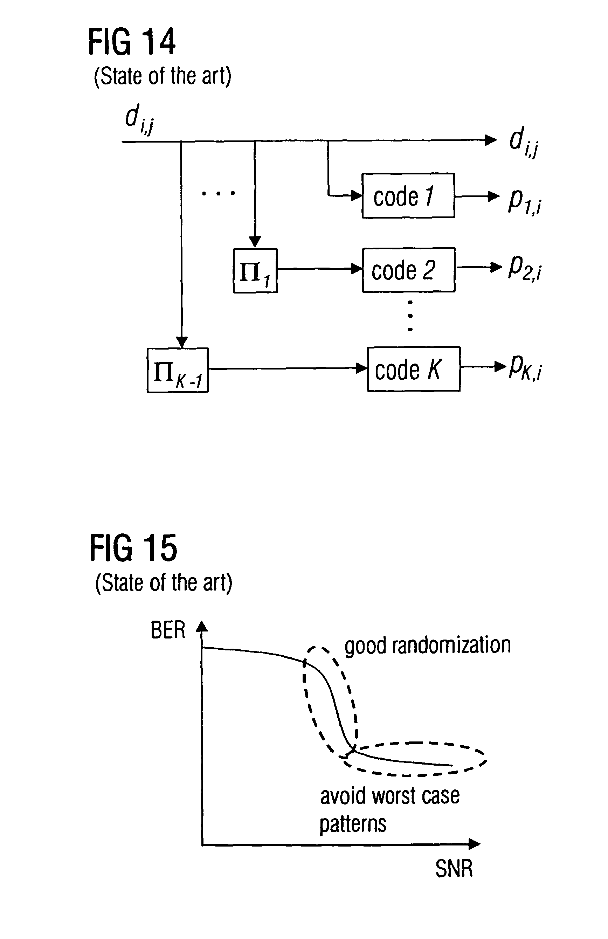

Fig. 15 schematically illustrates the performance in terms of bit error ratio over signal-to-noise-ratio. Typical interleaver design criteria for iterative decoding approaches can be derived from the view graph shown in Fig. 15. A good performance with iterative decoding can be obtained if good randomization is carried out by the interleaving rule, which is indicated in the view graph. A good randomization supports a steep slope of the bit error rate view graph. Another design criterion is the avoidance of the worst case patterns, as they cause a rather gentle slope of the bit error rate view graph and an error floor, as also indicated in Fig. 15.

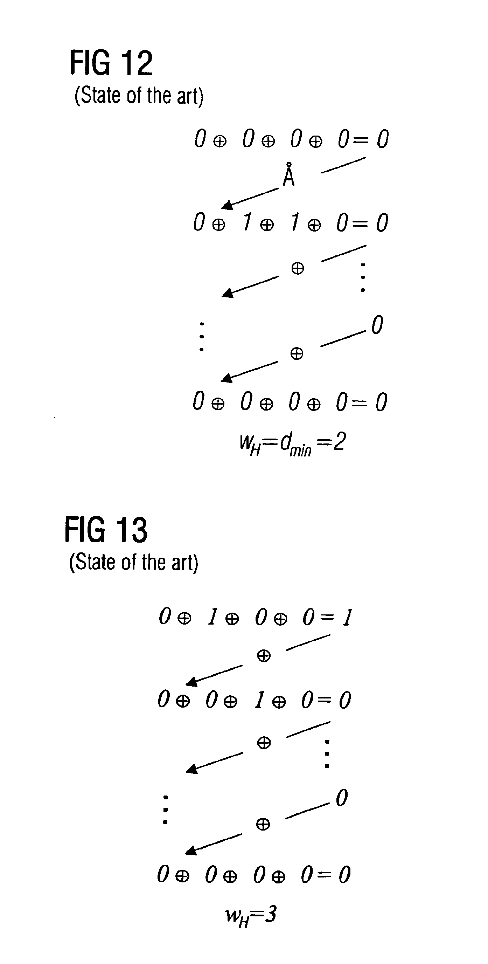

For the concatenated constituent codes, only the parity bits are transmitted. With $K$ constituent codes, the overall code rate becomes $R_c = J/(J + K)$. The use of multiple interleavers is an essential difference to turbo codes, where usually only two constituent codes are concatenated. This implies a new problem in interleaver design: Not only one interleaver, which is optimized for iterative decoding is needed but several interleavers are needed. Each of those interleavers should provide good performance of iterative decoding while the interleavers should be mutually as independent as possible. It is still an open problem what is a good criterion for mutual independency of multiple interleavers. One intuitive condition might be that, in order to increase the minimum Hamming distance of the overall code, the interleaving should make sure that bits which are within one segment at the input of a certain constituent encoder are not mapped to the same segment or adjacent segments at the input of any other constituent encoder. The problem is illustrated for an example in Fig. 12. Codewords with minimum Hamming weight $w_H = d_{min} = 2$ at the output of a zigzag constituent code are generated by data sequences, where two bits of value $d_{ij} = 1$ are located within the same segment $i$. In order to increase the minimum Hamming distance of the overall code, the interleaver should make sure that those data sequences produce a codeword with higher Hamming weight at the output of the other constituent encoders.

The representation in Fig. 11 suggests that a zigzag code can be decoded by a trellis based algorithm such as the BCJR algorithm in L. Bahl, J. Cocke, F. Jelinek, and J. Raviv, "Optimal decoding of linear codes for minimizing symbol error rate," IEEE Transactions on Information Theory, vol. IT-20, pp. 284-287, March 1974. At the decoder input, zeros have to be inserted at the positions of the punctured bits and for initialization of the backward recursion, all end states of the trellis may be assumed to be equally likely since the zigzag encoder is not terminated in a predetermined state. However, the division in segments allows the decoding of zigzag codes using a significantly less complex algorithm called the MLA algorithm which also executes a forward and a backward recursion. The simple version of the MLA algorithm as described in L. Ping, X. Huang, and N. Phamdo, "Zigzag codes and concatenated zigzag codes," IEEE Transactions on Information Theory, vol. 47, pp. 800-807, February 2001, works only for AWGN channels with constant SNR over a codeword. Here a more general description based on log-likelihood ratios that also works in time-varying channels and for higher order modulation is given. The noisy received values are denoted after demapping from the modulated symbols for data and parity bits, respectively, by $d_{i,j}$ and $p_i$, respectively. First, the channel information log-likelihood ratios are computed

$$L_c\left(d_{i,j}\right) = \log \frac{p(d_{i,j} = 0 | \widetilde{d}_{i,j})}{p(d_{i,j} = 1 | \widetilde{d}_{i,j})}, \qquad (1)$$

$$L_c(p_i) = \log \frac{p(p_i = 0 | \widetilde{p}_i)}{p(p_i = 1 | \widetilde{p}_i)} \qquad (2)$$

of the received codebits based on the channel statistics and the transmit symbol alphabet. Next, the possibly available a-priori information is taken

$$L_a(d_{i,i}) = \log \frac{P_a(d_{i,i} = 0)}{P_a(d_{i,i} = 1)} \qquad (3)$$

on the data bits into consideration by adding it to the channel information

$$L_{c\&a}(d_{i,j}) = L_c(d_{i,j}) + L_a(d_{i,j}). \qquad (4)$$

Now, a forward metric for the parity bits can be computed according to

$$F(p_1) = L_{c\&a}(p_1) + \sum_{\substack{j=1 \\ [+]}}^{J} L_{c\&a}(d_{1,j}) \tag{5}$$

$$F(p_i) = \underbrace{L_{c\&a}(p_i)}_{channel\&a-priori\,info} + \underbrace{\left( F(p_{i-1})[+]\sum_{\substack{j=1 \\ [+]}}^{J} L_{c\&a}(d_{i,j}) \right)}_{\substack{extrinsic\,info \\ i=2,\dots,J,}} \tag{6}$$

where $\displaystyle\sum_{\substack{j=1 \\ [+]}}^{J} a_j = a_1[+]a_2[+]..[+]a_J$ denotes the boxplus sum. The boxplus sum is the operation with log-likelihood ratios which corresponds to the modulo 2 sum of the respective bits as shown by J. Hagenauer, E. Offer, and L. Papke, "Iterative decoding of binary block and convolutional codes," IEEE Transactions on Information Theory, vol. IT-42, pp. 425-429, March 1996, i.e.

$$L(a_1 \oplus a_2) = L(a_1)[+]L(a_2). \tag{7}$$

The exact expression for the boxplus sum is given by J. Hagenauer, E. Offer, and L. Papke, "Iterative decoding of binary block and convolutional codes," IEEE Transactions on Information Theory, vol. IT-42, pp. 425-429, March 1996.

$$L(a_1)[+]L(a_2) = \log\frac{1 + e^{L(a_1)}e^{L(a_2)}}{e^{L(a_1)} + e^{L(a_2)}} \tag{8}$$

It can be approximated by

$$L(a_1)[+]L(a_2) \approx sign\{L(a_1)\}\, sign\{L(a_2)\}\, \min\{|L(a_1)|, |L(a_2)|\} \tag{9}$$

The first term in (6) is the direct channel info on the parity bit $p_i$ plus a-priori info, the second term is extrinsic information, i.e. the information about $p_i$ which can be obtained from all the previous bits in the codeword due to the code constraints. Similarly, a backward recursion can be computed

$$B(p_i) = \underbrace{L_{c\&a}(p_i)}_{channel\&a-priori\,info} + \underbrace{\left( P(p_{i+1})[+]\sum_{\substack{j=1 \\ [+]}}^{J} L_{c\&a}(d_{i+1,j}) \right)}_{\substack{extrinsic\,info \\ i=0,\dots,J-1.}} \tag{10}$$

The APP log-likelihood ratios are then obtained from

$$L_{app}(d_{1,j}) = L_{c\&a}(d_{1,j})[+]B(p_1)[+]\sum_{\substack{l=1,l\neq j \\ [+]}}^{J} L_{c\&a}(d_{1,l})$$

$$L_{app}(d_{i,j}) = \underbrace{L_{c\&a}(d_{i,j})}_{\text{channel \& a-priori info}} \qquad (11)$$

$$\underbrace{+ F(p_{i-1})[+]B(p_i)[+]\sum_{\substack{l=1,l\neq j \\ [+]}}^{J} L_{c\&a}(d_{i,j})}_{\text{extrinsic info}} \qquad (12)$$

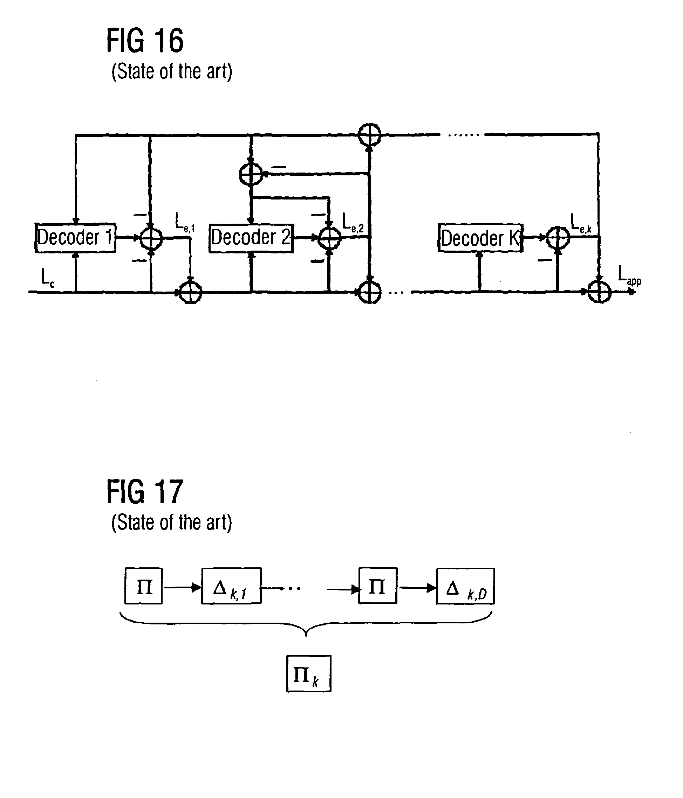

The first term in (12) is the direct channel info on the bit $d_{i,j}$ plus a-priori info, the other terms constitute extrinsic information, i.e. the information about $d_{i,j}$ which can be obtained from all other bits in the codeword due to the code constraints. Concatenated zigzag codes can be decoded by an iterative turbo algorithm as illustrated in Fig. 16 where the constituent codes are decoded in turn taking extrinsic information of the other constituent decoders into account as additional a-priori information. Interleavers are not shown in Fig. 16 for simplicity. Each constituent decoder 1 uses the received channel information $L_c(d_{i,j})$ and $L_c(p_{l,i})$ for the data bits and parity bits, respectively, as well as extrinsic information $L_{c,k}(d_{i,j})$ from the other constituent decoders as additional a-priori information $L_{a,l}(d_{i,j})$. Extrinsic information of a constituent decoder $l$ is defined by the difference

$$L_{e,l}(d_{i,j}) = L_{app,l}(d_{i,j}) - L_c(d_{i,j}) - L_{a,l}(d_{i,j}) \qquad (13)$$

of the output and input log-likelihood ratios. During iteration $n$, the a-priori information consists of the extrinsic information obtained in the current iteration $n$ from the already decoded constituent decoders $k = 1, ..., l-1$ and the extrinsic information from decoders $k=l+1, ..., K$ which was obtained in the previous iteration $n-1$.

For the concatenation of several zigzag constituent codes, $K$-1 different interleavers are needed. In general, multiple interleavers can be generated randomly. However, apart from the fact that it cannot be guaranteed that interleavers with good mutual properties are generated, a significant practical problem appears in terms of memory requirements since each of the $K$-1 permutation pattern needs to be stored. Moreover, a system may have to support various block lengths. In this case, we have to store $K$ interleaver patterns for each possible block length. Therefore, we wish to generate multiple interleavers from a simple equation or by simple operations on a common mother interleaver.

The problem of saving memory for multiple interleavers has been addressed in the context of zigzag codes in N. Nefedov, "Multi-dimensional zigzag codes for high data rate transmission", in 3rd International Symposium on Turbo Codes and Related Topics, pp. 215-218, September 2003. and N. Nefedov, "Evaluation of low complexity concatenated codes for high data rate transmission," in 14th International Symposium on Personal, Indoor and Mobile Radio Communications, pp. 1868-1872, September 2003.

Here, it is proposed to build a multidimensional zigzag code by arranging the data bits in a cube and performing zigzag encoding in various directions through the cube. However, by doing so, the design space is limited and particularly the parameter $J$ of the constituent zigzag codes may be fixed and differ.

In N. Nefedov, "Evaluation of low complexity concatenated codes for high data rate transmission", in 14th International Symposium on Personal, Indoor and Mobile Radio Communications, pp. 1868-1872, September 2003, a proposal is presented which allows to use zigzag codes and the parallel concatenated convolutional codes as specified for UMTS within the same framework. As far as interleaving is concerned, the author proposes to use the interleaver specified for the UMTS turbo code and its transpose as the interleaver for a third concatenated constituent zigzag code. Even though this scheme is very simple, it is limited to two interleavers. It is further suggested by N. Nefedov to produce additional interleavers from the UMTS interleaver by swapping of addresses of the interleaver. However, no information is given on how this should be done.

Only a few papers on design of multiple interleavers exist and an appropriate design criterion is still an open problem.

Multiple interleavers are considered in A. Tarable, G. Montorsi, and S. Benedetto, "Analysis and design of interleavers for iterative multi-user receivers in coded CDMA systems," IEEE Transactions on Information Theory, vol. 51, pp. 1650-1666, May 2005 and S. Brück, U. Sorger, S. Gligorevic, and N. Stolte, "Interleaving for outer convolutional codes in DS-CDMA systems," IEEE Transactions on Communications, vol. 48, pp. 1100-1107, July 2000 in the context of multi-user detection in code division multiple access (CDMA), and K. Kusume and G. Bauch, "Cyclically shifted multiple interleavers," in Globecom, IEEE, November/December 2006, and K. Kusume and G. Bauch, "Some aspects of interleave division multiple access in ad hoc networks," in 4th International Symposium on Turbo Codes and Related Topics, April 2006 or interleave division multiple access (IDMA).

Multiple interleavers for multidimensional turbo codes are proposed in A. Barbulescu and S. Pietrobon, "Interleaver design for three dimensional turbo codes," in IEEE International Symposium on Information Theory, p. 37, September 1995, N. Ehtiati, M. Soleymani, and H. Sadjadpour, "Interleaver design for multiple turbo codes," in Canadian Conference on Electrical and Computer Engineering, pp. 1605-1607, May 2003 and N. Ehtiati, M. Soleymani, and H. Sadjadpour, "Joint interleaver design for multiple turbo codes," in IEEE Vehicular Technology Conference (VTC Fall), pp. 2302-2306, September 2004. In S. Brück, U. Sorger, S. Gligorevic, and N. Stolte, "Interleaving for outer convolutional codes in DS-CDMA systems", IEEE Transactions on Communications, vol. 48, pp. 1100-1107, July 2000, the authors derive design criteria for random congruential interleavers in order to minimize the impact of multi-user interference under the condition of certain convolutional codes. A disadvantage is that if the code properties are changed, e.g. by puncturing in a rate-adaptive coding scheme, the interleavers have to be changed. Furthermore, a minimum interleaver size is required in order to meet the design criteria.

Particularly, for low rate codes this minimum interleaver size becomes prohibitively large. Another design criterion is discussed in A. Tarable, G. Montorsi, and S. Benedetto, "Analysis and design of interleavers for iterative multiuser receivers in coded CDMA systems," IEEE Transactions on Information Theory, vol. 51, pp. 1650-1666, May 2005, where the authors use the heuristic criterion of minimizing the intersection, i.e. the set of common codewords, between the resulting codewords after interleaving.

However, it turns out those interleavers, which violate this criterion, but instead satisfy criteria on individual interleavers for good turbo processing, show a better performance. This again stresses the difficulties in finding appropriate design criteria and justifies relying more on heuristic approaches and evaluation by simulations. Furthermore, except for the case of congruential symbol interleavers in combination with convolutional codes, no construction methods are given in A. Tarable, G. Montorsi, and S. Benedetto, "Analysis and design of interleavers for iterative multi-user receivers in coded CDMA systems," IEEE Transactions on Information Theory, vol. 51, pp. 1650-1666, May 2005. The heuristic approach taken in K. Kusume and G. Bauch, "Cyclically shifted multiple interleavers," in Globecom, IEEE, November/December 2006, K. Kusume and G. Bauch, "Some aspects of interleave division multiple access in ad hoc networks," in 4th International Symposium on Turbo Codes and Related Topics, April 2006 will be explained in more detail below.

Interleaver design in the context of multidimensional parallel concatenated convolutional codes is addressed in N. Ehtiati, M. Soleymani, and H. Sadjadpour, "Interleaver design for multiple turbo codes," in Canadian Conference on Electrical and Computer Engineering, pp. 1605-1607, May 2003 and N. Ehtiati, M. Soleymani, and H. Sadjadpour, "Joint interleaver design for multiple turbo codes," in IEEE Vehicular Technology Conference (VTC Fall), pp. 2302-2306, September 2004. Here, the fact that data sequences, which are divisible by the feedback polynom of the recursive convolutional constituent codes, produce low weight codewords is taken into account. The interleaver should permute those divisible patterns to non-divisible patterns. In order not to put to many restrictions on one interleaver, the idea in N. Ehtiati, M. Soleymani, and H. Sadjadpour, "Interleaver design for multiple turbo codes," in Canadian Conference on Electrical and Computer Engineering, pp. 1605-1607, May 2003, N. Ehtiati, M. Soleymani, and H. Sadjadpour, "Joint interleaver design for multiple turbo codes," in IEEE Vehicular Technology Conference (VTC Fall), pp. 2302-2306, September 2004 is that each interleaver takes care of a subset of critical patterns which have to be broken. This ensures that at least one constituent code contributes weight to the codeword. However, the design criteria are limited to parallel concatenated convolutional codes and depend on the particular choice of the constituent codes. Furthermore, no simple construction method is given which would allow low cost implementation. The proposal in A. Barbulescu and S. Pietrobon, "Interleaver design for three dimensional turbo codes", in IEEE International Symposium on Information Theory, p. 37, September 1995 is limited to parallel concatenation of three convolutional codes and focuses on small block lengths. Here, the goal is to ensure that all constituent codes terminate in the same state.

Congruential interleavers offer a straightforward approach, which allows constructing multiple interleavers for different block lengths from a simple equation. However, congruential interleavers introduce limited randomness, which results in sub-optimum performance.

A simple method to construct multiple interleavers is to use congruential interleavers with different seed. The permutation rule of a congruential interleaver is given by S. Crozier, J. Lodge, P. Guinand, and A. Hunt, performance of turbo-codes with relative prime and golden interleaving strategies", in International Mobile Satellite Conference, pp. 268-275, 1999

$$\Pi_k(n) = s_k + nc_k \bmod N, n = 0,\ldots,N-1, \qquad (14)$$

where $s_k$ is an integer starting value, $N$ is the interleaver size and $c_k$ is an integer, which must be relatively prime to $N$ in order to ensure a unique mapping. Multiple interleavers can be generated by using different $c_k$ and $s_k$. The values of $c_k$ may be chosen such that adjacent bits in the data sequence are mapped to positions with a predetermined minimum spacing of $s$ bits. In this case, the interleaver is called an s-random congruential interleaver.

Generating multiple interleavers from one common mother interleaver using cyclic shifts and self-interleaving was proposed in K. Kusume and G. Bauch, "Cyclically shifted multiple interleavers," in Globecom, IEEE, November/ December 2006, K. Kusume and G. Bauch, "Some aspects of interleave division multiple access in ad hoc networks," in 4th International Symposium on Turbo Codes and Related Topics, April 2006 in the context of interleave division multiple access (IDMA) where users with low rate FEC coding are separated by different interleavers. The advantage is that only a single interleaving pattern has to be stored. Other interleavers can be constructed if needed based on very few parameters, i.e. the cyclic shifts. The use of cyclic shifts for generation of multiple interleavers is motivated by an observation for multi-user detection which showed that a synchronism between users, i.e. the user's signals arrive with different delay at the multi-user receiver, allows to separate them as well as user-specific random interleavers even if the same interleaver is used for all users K. Kusume and G. Bauch, "Cyclically shifted multiple interleavers", in Globecom, IEEE, November/December 2006. It was proposed to construct the interleaving pattern $\Pi_k$ for user $k$ from a common interleaver n by user-specific cyclic shifts $\Delta_{k,c}$ and interleaving of the permutation pattern by itself as indicated in Fig. 17. With about $D = 3$ such cyclic shifts and self-interleaving operations, the same performance as with randomly chosen interleavers could be obtained in IDMA with synchronous users.

EP 1441448 A2 discloses a data coder including a combined parallel concatenated convolution coder (PCCC) and a parallel concatenated zigzag (PCZZ) coder, where PCCC functional blocks are reused in the PCZZ coder for coding at high coding rates. For the PCZZ coder, one interleaver and its transposed versions are used. The PCZZ coding rate may be changed by repositioning at least one interleaver pattern according to several parameters. A second interleaver for the PCZZ coder is obtained by a transform of an initial interleaving vector or matrix. Alternatively, the PCZZ coder reuses a PCCC interleaver.

It is the object of the present invention to provide an encoder and a decoder for zigzag codes, which provide improved performance.

The object is achieved by an encoder according to claim 1, a method for encoding according to claim 9, a decoder according to claim 11, and a method for decoding according to claim 12.

The present invention is based on the finding that existing communication systems can be easily enhanced with zigzag encoding and decoding for its lower complexity, and proper interleaving rules can be derived from existing interleavers. For example, interleaving rules can be generated from a common mother interleaver by simple operations such a cyclic shifts, self-interleaving, or matrix transposition. This provides the advantage that only the mother interleaver or its construction rule has to be stored. Any interleaver, for example, the interleaver which has been specified for turbo codes in UMTS (UMTS = Universal Mobile Telecommunication System), 3GPP, "Turbo code internal interleaver", in *3G TS 25.212 V3.2.0 (2000-03), Release 1999,* 2000, can be used as a mother interleaver.

An advantage can be obtained by using intermediate steps from the construction of the interleaver specified for turbo codes in UMTS, in order to obtain several interleavers for zigzag coding. This provides the advantage that the building blocks, i.e. a de-interleaver, which is available in a system such as UMTS can be reused, if for example, zigzag codes are introduced as an optional coding scheme. This allows the use of turbo codes and zigzag codes within the same framework. Both coding schemes could share the building blocks for interleaver construction, even though zigzag codes need more interleavers than turbo codes.

Embodiments of the present invention provide the advantage, that systems using coding schemes being different from zigzag codes can be extended with zigzag coding without introducing high complexity, as additional interleavers can be derived from the existing interleavers.

Embodiments of the present invention will be detailed using the Figures attached, and which

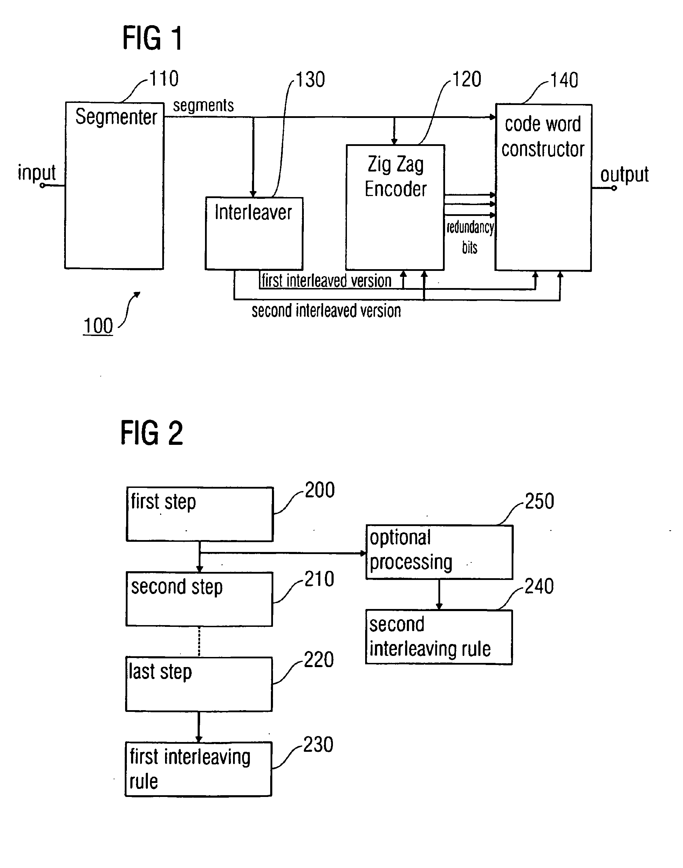

Fig. 1 shows an embodiment of an encoder;

Fig. 2 shows an embodiment of a derivation of an additional interleaving rule;

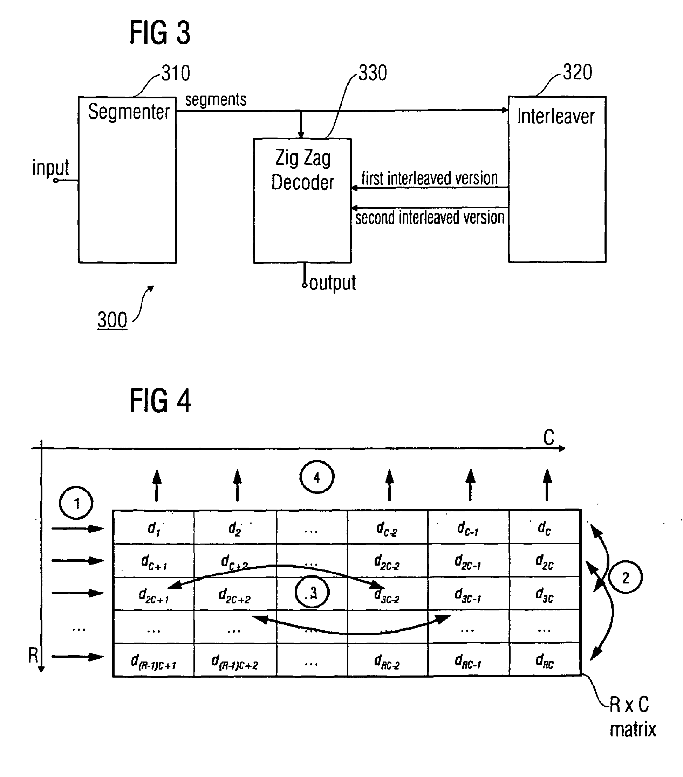

Fig. 3 shows an embodiment of a decoder;

Fig. 4 illustrates the UMTS interleaving rule;

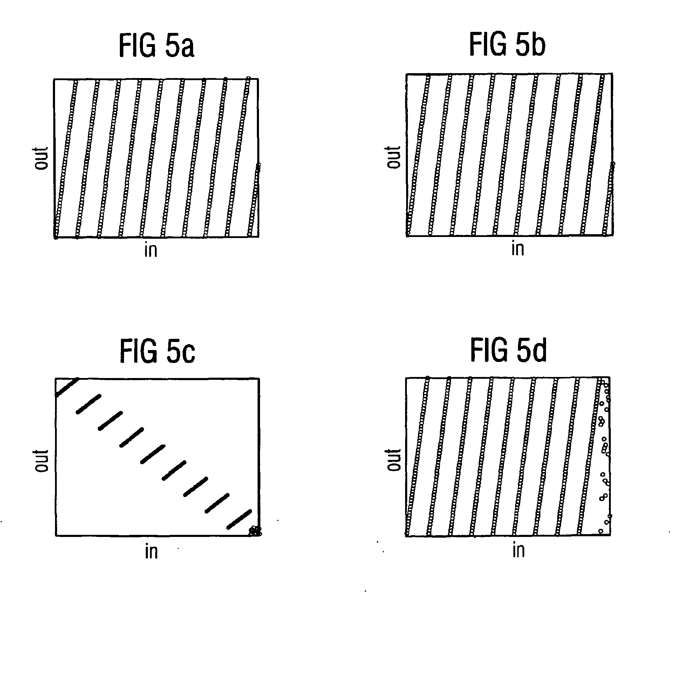

Fig. 5a to 5h illustrate different sub-steps of an interleaving rule;

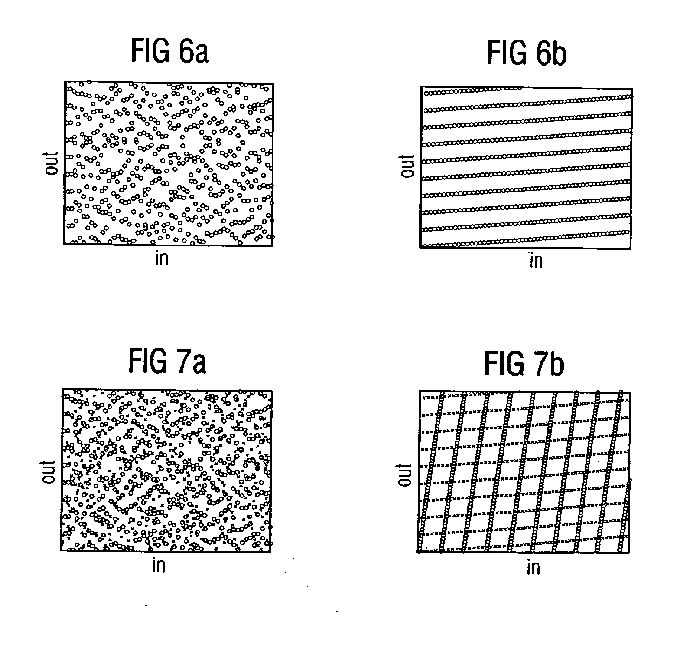

Fig. 6a and Fig. 6b show two examples of transposed interleaver outputs;

Fig. 7a and 7b illustrate two further examples of interleaver outputs and transpositions thereof;

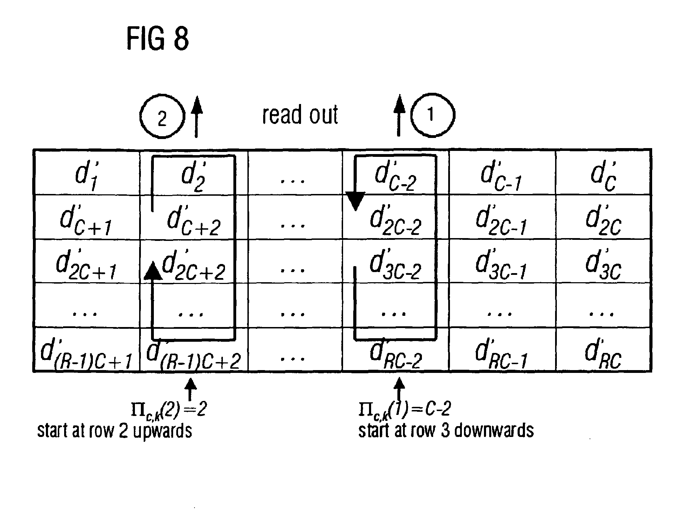

Fig. 8 illustrates an embodiment of further randomization of an interleaving rule;

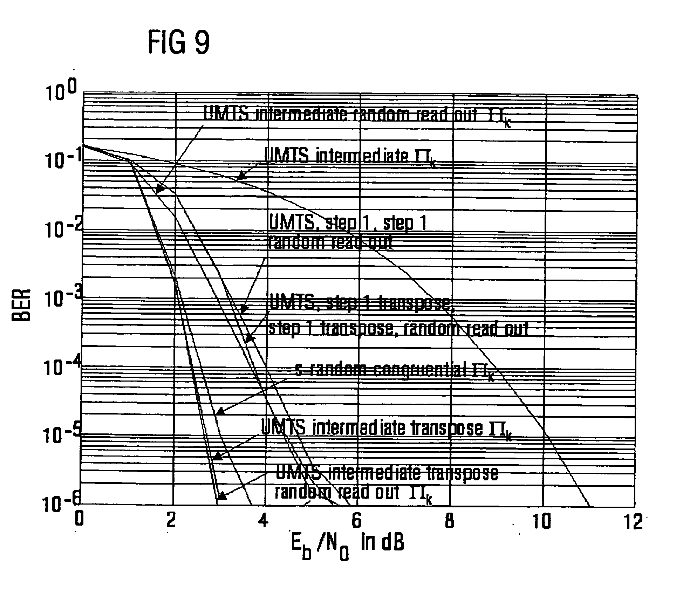

Fig. 9 shows bit error rates obtained with modified intermediate UMTS interleaving rules;

Fig. 10 illustrates state of the art zigzag codes;

Fig. 11 shows a block diagram of the state of the art zigzag encoder;

Fig. 12 shows a low Hamming distance zigzag encoded codeword;

Fig. 13 shows another example of a zigzag encoded codeword;

Fig. 14 shows a state of the art concatenated zigzag encoder;

Fig. 15 shows a view graph illustrating the bit error rate performance of interleaving rules;

Fig. 16 shows a state of the art decoder for concatenated zigzag codes;

Fig. 17 shows a state of the art interleaver based on cyclic shifts.

Fig. 1 shows an embodiment of an encoder 100 for generating an output codeword based on an input information word, the input information word having fewer bits than the output codeword. The encoder 100 comprises a segmenter 110, a zigzag encoder core 120, an interleaver 130, and an output codeword constructor 140.

The encoder 100 comprises the segmenter 110 for segmenting the input information word into a plurality of ordered segments, the segments having bits. The zigzag encoder core 120 is adapted to calculating a redundancy bit for a current segment, wherein a redundancy bit of an earlier segment in the order is used when calculating the redundancy bit for the current segment. The encoder 100 comprises the interleaver 130 for interleaving the bits of the plurality of segments using a first interleaving rule to obtain a first interleaved version and for interleaving the bits of the plurality of segments using a second interleaving rule to obtain a second interleaved version, were the interleaver 130 is designed to generate the first interleaving rule as a predefined interleaving rule obtained by conducting a predefined number of sequenced intermediate sub-steps. The output codeword constructor 140 is adapted for constructing the output codeword, using the input codeword or an interleaved version thereof, a set of first redundancy bits generated by the zigzag encoder core 120 fed by the first interleaved version, and a set of second redundancy bits, generated by the zigzag encoder core 120 fed by the second interleaved version. The interleaver 130 is adapted to use, as the second interleaving rule, an intermediate interleaving rule obtained by conducting a first sub-step or a number of sub-steps less than the predefined number of sub-steps or an interleaving rule obtained by processing the intermediate interleaving rule in a different manner, compared to the remaining sub-steps.

In one embodiment the predefined interleaving rule can be optimized for an encoding operation, which is different from the encoding operation performed by the zigzag encoder core 120. The predefined interleaving rule could, for example, be optimized for a concatenated convolution code or a turbo code. In one embodiment the predefined interleaving rule corresponds to the UMTS interleaver, which is specified in the 3GPP (3GPP = Third Generation Partnership Project) specification TS 25.212. In another embodiment the interleaver 130 can be adapted for processing the intermediate interleaving rule corresponding to a matrix transposition or a row or column exchange of an intermediate interleaving matrix.

Fig. 2 shows a block diagram of a predefined interleaving rule. The predefined interleaving rule comprises a first step 200, a second step 210, a number of intermediate steps, and a last step 220. The sequence of these steps resulting in a first interleaving rule 230, which can, for example, be given by a matrix, which assigns indices of an input information codeword to indices of an interleaved version of the input information codeword. Fig. 2 further shows the determination of a second interleaving rule 240, which can, for example, be obtained by taking an intermediate result after the first step 200 from the process of deriving the first interleaving rule 230, followed by an optional processing 250. The optional processing 250 can comprise matrix transpositions, rowwise or columnwise readouts of intermediate interleaving matrices, wherein the readouts can be random, i.e. according to a randomized order of rows or columns.

The example depicted in Fig. 2 takes as an example, the intermediate result after the first step 200. Generally, embodiments of the present invention can take any intermediate step from a predefined interleaving rule.

Fig. 3 shows an embodiment of a decoder 300. The decoder 300 for decoding an input codeword and for generating an output information word, the output information word having fewer bits than the input codeword, comprises a segmenter 310, an interleaver 320, and a zigzag decoder 330. The segmenter 310 is adapted for segmenting the input codeword into a plurality of ordered segments, a segment having information bits and redundancy bits. The interleaver 320 is operative for interleaving information bits of the plurality of segments using a first interleaving rule to obtain a first interleaved version of the information bits and for using a second interleaving rule to obtain a second interleaved version of the information bits, where the interleaver 320 is designed to generate the first interleaving rule as a predefined interleaving rule obtained by conducting a predefined number of sequenced intermediate sub-steps.

The zigzag decoder 330 is adapted for calculating the output information word based on the information bits, the first interleaved version of the information bits the second interleaved version of the information bits, and the redundancy bits. The interleaver 320 is further adapted to use as the second interleaving rule an intermediate interleaving rule obtained by conducting a first sub-step or a number of sub-steps, less than the predefined number of sub-steps, or an interleaving rule obtained by processing the intermediate interleaving rule in a different manner, compared to the remaining sub-steps.

In one embodiment the predefined interleaving rule is based on the UMTS interleaver, which is defined for parallel concatenated convolutional codes (turbo codes), and which is optimized for performance in iterative decoding of turbo codes while allowing relatively simple construction for different interleaver sizes. It is designed in order to avoid worst-case patterns for turbo codes, data sequences with Hamming weights $w_H = 2$ where the two 1-bits have a distance of three bits are most critical, for example, a data sequence d = (0,...0,1,0,0,1,0,...0), cf. D. Divsalar and F. Pollara, "Multiple turbo codes for deep-space communications," TDA Progress Report 42-121, May 1995 and T. Sohdoh, N. Nishinaga, and Y. Iwadare, "The new interleaver design of turbo codes for error floor improvement," in 20th Symposium on Information Theory and its Applications, pp. 13-16, December 1997. These patterns are broken by the UMTS interleaver, i.e. they are not mapped to a sequence where the two 1-bits have again a distance of three.

However, the problem of multiple interleavers was not considered with respect to this interleaver. One embodiment is to obtain a second interleaver by using the transpose of the permutation matrix of the UMTS interleaver, and to obtain further interleavers by reading out permutation rules at intermediate steps of the UMTS interleaver construction. The UMTS interleaver is constructed in several steps as illustrated in Fig. 4. Fig. 4 shows a R x C matrix with data elements $d_1,...,d_{RC}$. In a first step, as indicated by step 1 in the Fig. 4, the data bits are written row by row into the R x C matrix. The values of R and C depend on the interleaver size, i.e. they vary with different configurations given in the UMTS specifications. As a next step, indicated by step 2 in Fig. 4, rows are exchanged according to certain rules, of which details are also given in the UMTS specifications according to 3GPP, "Turbo code internal interleaver", in *3G TS 25.212 V3.2.0 (2000-03), Release 1999,* 2000. In a third step, as indicated by step 3 in Fig. 4, intra-row permutations are performed within the rows. In a last step, step 4 in Fig. 4, the permutated bits are read out column by column.

Embodiments can generate multiple interleavers by reading out an immediate permutation rule at each step, either columnwise to rowwise. For example, reading out column by column after each step, i.e. writing data into a matrix, would yield a block interleaver. After the row exchange, in step 2, interleavers can be obtained by reading out column-by-column or row-by-row, which yields two additional interleavers. The very same can be done after each intra-row permutation step. Naturally, not all those interleavers will show a good performance. This shall be illustrated in the graphical interleaver representations in Figs. 5a to 5h. In each of the Figs. 5a to 5h the abscissa indicates the index in the original data sequence labeled by "in" whereas the ordinate represents the data index after interleaving indicated by the label "out".

Fig. 5a shows the interleaver after step 1, which is read out columnwise. The resulting interleaver is a block interleaver.

Fig. 5b shows the same interleaver after step 2, which is again read out columnwise. The difference to Fig. 5a shows in the order of the starting indices of the respective columns.

Fig. 5c shows the interleaver after intra-row permutation of row 1, which is done in step 3 of the UMTS interleaver. The view graph shown in Fig. 5c is the result of a rowwise readout of the input matrix.

Fig. 5d shows the same interleaver, however, the view graph shown in Fig. 5d results from reading out the matrix columnwise.

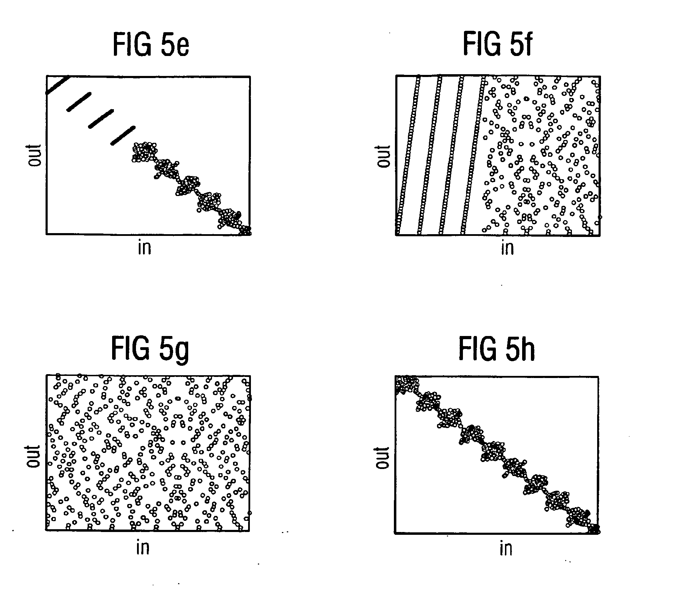

Figs. 5e and 5f show the interleaver after intra-row permutation of row 6 in step 3 of the UMTS interleaver, where Fig. 5e shows the resulting interleaver for reading out rowwise, Fig. 5f shows respectively the resulting interleaver for reading out columnwise.

Figs. 5g and 5h show the resulting interleavers after the full UMTS interleaving rule has been applied to the input matrix. Fig. 5g shows the result when reading out columnwise, Fig. 5h shows the result when reading out rowwise.

From the Figs. 5a to 5h, it can be seen that the plots for the UMTS interleaver are almost uniformly spread, whereas the block interleaver which results by reading out columnwise after step 1 is highly structured. It can be observed that reading out rowwise yields interleavers which in contrast to the UMTS interleaver are only locally randomized, as for example, shown in Figs. 5h or 5e. The more intra-row permutations have been performed in step 3 of the predefined UMTS interleaver construction, the less structured the resulting interleaver.

Embodiments can improve the spreading properties of those intermediate interleavers by simple operations. One possibility is to use the matrix transposition $\Pi^T_k$ of the respective permutation matrix rather than $\Pi_k$ itself. Actually, $\Pi^T_k$ is the de-interleaver corresponding to $\Pi_k$. Therefore, this operation imposes no additional complexity compared to using $\Pi_k$ directly, since in a bi-directional communication, the deinterleaving rule has to be determined anyway. The roles of interleaver and de-interleaver can be exchanged. An iterative decoder anyway needs both the interleaver and the de-interleaver. The graphical representation of some of those transposed intermediate interleavers is given in Figs. 6a and 6b, where a similar depiction is used as in the Fig. 5a to Fig. 5h.

Fig. 6a shows the transposition of the UMTS interleaver, whereas Fig. 6b shows the transposition of a block interleaver resulting from a columnwise readout of the interleaver matrix as step 1. Again, it can be observed from Fig. 6a and Fig. 6b that the block interleaver depicted in Fig. 6b is highly structured, while the transpose of the UMTS interleaver shown in Fig. 6a is randomized. The Fig. 7a and Fig. 7b show the original intermediate interleavers and their transpose within the same Fig., where a similar depiction is used as in the Fig. 5a to Fig. 5h. The original versions are indicated by circles while their respective transpositions are indicated by crosses.

Fig. 7a shows the UMTS interleaver and its transposition, whereas in Fig 7b the block interleaver resulting from step 1 and columnwise readout and its transpositions are shown. Interestingly, even for the final UMTS interleaver, the original version and its transpose have almost no mappings in common. This serves as a hint for good mutual independency and indicates applicability in concatenated zigzag codes. Another method for additional randomization is obtained by embodiments by modifying the order in which the interleavers are read out. Fig. 8 indicates how embodiments further randomize the interleavers. Fig. 8 shows the RxC-matrix as it was already described above, indicating that it is read out columnwise, however, the columns are not read out in order, but in randomized order, and the starting values are randomized as well. The example depicted in Fig. 8 indicates that column (C-2) is read out first, starting at row 3 going downwards to the last element of the column, followed by the first and second elements. In a second step, column 3 is read out, starting with the second element, followed by the first element followed by the last element, etc.

In another embodiment permutation rule of a congruential interleaver in order to determine the order in which the columns are read out is used. For example, C could be the number of columns, then the order in which the columns are read out can be determined according to

$$\Pi_{c,k}(i_c) = s_{c,k} + c_{c,k}i_c \bmod C, i_c = 0,...C-1 .\qquad (15)$$

Where $c_{c,k}$ is an integer, which must be relatively prime to C in order to ensure that each column is read out once and only once. $s_{c,k}$ is an integer starting value. Both $c_{c,k}$ and $s_{c,k}$ can be randomly chosen and should be different for different interleavers $\Pi_k$. Column $i_c$ is read out as the $\Pi_{c,k}(i_c)$-th column. The special case $c_{c,k} = 1$ yields just a cyclic shift by $s_{c,k}$ of the order in which the columns are read out.

In another embodiment the row index at which reading out of column $i_c$ starts can be randomly chosen or chosen according to a predetermined rule. Furthermore in embodiments it may be specified that a certain row $i_c$ is read out upwards, i.e. toward lower row indices, or downwards, i.e. toward higher row indices, in a cyclic manner. In order to obtain more or improved interleavers, embodiments may take the transposition of the permutation matrices for all or some of the interleavers which are generated by the modified read process.

Generally, any predetermined interleaving rules or interleavers can be used with the abovementioned embodiments in order to derive or determine respective interleavers.

In one embodiment an interleaver $\Pi_k$ may use the complete UMTS interleaver for determining $\Pi_1$. $\Pi_2 = \Pi^T_1$ may be constructed as the transpose of $\Pi_1$. For $\Pi_3$ a block interleaver may be used, which may result from reading out the data column by column after step 1 of Fig. 4. The next interleaver $\Pi_4$ may be obtained by reading out column by column after the row exchange in step 2 of Fig. 4. By doing so, interleavers can be obtained which have very few bit mappings in common.

Performance results for zigzag codes with parameters I = 256, J = 4, K = 4 and interleavers which are constructed from intermediated UMTS interleavers are depicted in Fig. 9. The view graphs in Fig. 9 were determined, using the full UMTS interleaver, and the block interleaver after step 1 of Fig. 5 in the interleaver constructions as well as their transpositions and randomly read out versions as intermediate interleavers. The worst performance is obtained, when the UMTS interleaver is used, together with the rowwise read UMTS interleaver and the block interleaver after step 1 of Fig. 4. This is due to the disadvantageous only local permutation obtained when reading the UMTS interleaver out row-wise. The performance can be significantly improved, if the same intermediate interleavers are used but randomly read out as suggested above. As indicated in Fig. 9 the best performance is obtained for the UMTS intermediate transpose

randomly read out $\Pi_k$. Very good performance is obtained, when the UMTS interleaver, its transposition and the block interleaver after step 1 of Fig. 4 are used. The performance of this combination can even be slightly improved by reading out randomly. The interleaving schemes outperform the s-random congruential interleaver, of which a bit error ratio is also given in Fig. 9. The performance when using the transpose of the block interleaver after step 1 instead of the transpose of the UMTS interleaver is similar to that when randomly reading three different intermediate interleavers.

Embodiments enable a low cost implementation of coding schemes with a significantly smaller complexity and competitive performance compared to UMTS turbo codes. The chip area and battery consumption can be reduced and high decoder throughput can be enabled. Embodiments can, for example, use the construction method of the UMTS interleaver yielding low complexity and low memory requirements. Only one interleaver construction rule is needed, as for the other interleavers, intermediate steps of the full interleaver construction can be utilized. Embodiments further provide the advantage that, for example, turbo codes and zigzag codes can be used in the same framework.

Embodiments can be implemented economically, as interleaver components, for example the UMTS turbo code, can be used. Modifications to existing systems for introduction of zigzag codes as a new coding scheme are minimized with such embodiments. Furthermore, embodiments can be used to construct multiple interleavers for other applications, for example, to improve multi-user detection in an IDMA-system.

Depending on certain implementation requirements of the inventive methods, the inventive methods can be implemented in hardware or in software. The implementation can be performed using a digital storage medium, in particular, a disc, DVD or a CD having an electronically readable control signal stored thereon, which cooperates with a programmable computer system, such that the inventive methods are performed. Generally, the present invention is, therefore, a computer program product with a program code stored on a machine-readable carrier, the program code being operative for performing the inventive methods when the computer program product runs on a computer. In other words, the inventive methods are, therefore, a computer program having a program code for performing at least one of the inventive methods when the computer program runs on a computer.

**Claims**

1. Encoder (100) for generating an output code word based on an input information word, the input information word having fewer bits than the output codeword, comprising:

   a segmenter (110) for segmenting the input information word into a plurality of ordered segments, the segments having bits;
   a zigzag encoder core (120) for calculating a redundancy bit for a current segment, wherein a redundancy bit of an earlier segment in the order is used when calculating the redundancy bit for the current segment;
   an interleave (130) for interleaving the bits of the plurality of segments using a first interleaving rule to obtain a first interleaved version and for interleaving the bits of the plurality of segments using a second interleaving rule to obtain a second interleaved version, where the interleaver (130) is designed to generate the first interleaving rule as a predefined interleaving rule obtained by conducting a predefined number of sequenced intermediate sub-steps; and
   an output codeword constructor (140) for constructing the output codeword using the input codeword or an interleaved version thereof, a set of first redundancy bits generated by the zigzag encoder core (120) fed by the input codeword or the first interleaved version, and a set of second redundancy bits generated by the zigzag encoder core (120) fed by the second interleaved version,
   wherein the interleaver (130) is adapted to use, as the second interleaving rule, an intermediate interleaving rule obtained by conducting a number of sub-steps of the predefined number of sequenced intermediate sub-steps, the number of sub-steps being lower than the predefined number of sequenced intermediate sub-steps by an omitted number of sub-steps, or an interleaving rule obtained by processing the intermediate interleaving rule in a different manner compared to the omitted number of sub-steps.

2. Encoder (100) of claim 1, wherein the predefined interleaving rule is optimized for an encoding operation different from the encoding operation performed by the zigzag encoder core (120).

3. Encoder (100) of one of the claims 1 or 2, wherein the predefined interleaving rule is optimized for a concatenated convolutional code or turbo code.

4. Encoder (100) of one of the claims 1 to 3, wherein the predefined interleaving rule comprises the sub-steps of:

   generating an R x C input matrix, having R rows, each row corresponding to a segment having C bits of the input information word;
exchanging rows of the input matrix;
exchanging elements within the exchanged rows of the input matrix;
reading out the input matrix having the exchanged rows and the exchanged elements column-wise.

5. Encoder (100) of one of the claims 1 to 4, wherein the predefined interleaving rule corresponds to the interleaving rule defined in the 3GPP specification TS 25.212, Version 3.2.0, 2000-03, release 99.

6. Encoder (100) of one of the claims 1 to 5, wherein the interleaver (130) is adapted for processing the intermediate interleaving rule corresponding to a matrix transposition or a row or column exchange of an intermediate interleaving matrix from the predefined interleaving rule.

7. Encoder (100) of one of the claims 4 to 6, wherein a permutation rule of a congruential interleaver is used to determine an exchange of rows or columns.

8. Encoder (100) of one of the claims 6 or 7, wherein the processing further comprises a readout operation on a matrix with a readout rule, the readout rule being such that rows or columns are exchanged, rows or columns are read out backwards, rows or columns are read out in randomized order, or combinations thereof.

9. Method for encoding by generating an output codeword based on an input information word, the input information word having less bits than the output codeword, comprising the steps of:

segmenting the input information word into a plurality of ordered segments, the segments having bits;
calculating a redundancy bit for a current segment based on a zigzag code, wherein a redundancy bit of an earlier segment in the order is used for calculating the redundancy bit for the current segment;
interleaving the bits of the plurality of segments using a first interleaving rule to obtain a first interleaved version and for interleaving the bits of the plurality of segments using a second interleaving rule to obtain a second interleaved version, where the interleaving is designed to generate the first interleaving rule as a predefined interleaving rule obtained by conducting a predefined number of sequenced intermediate sub-steps;
constructing the output codeword using the input codeword or an interleaved version thereof, a set of first redundancy bits calculated based on the input codeword or the first interleaved version and a set of redundancy bits calculated based on the second interleaved version;
wherein the interleaving uses as the second interleaving rule, an intermediate interleaving rule obtained by conducting a number of sub-steps of the predefined number of sequenced intermediate sub-steps, the number of sub-steps being lower than the predefined number of sequenced intermediate sub-steps by an omitted number of sub-steps, or an interleaving rule obtained by processing the intermediate interleaving rule in a different manner compared to the omitted number of sub-steps.

10. Computer program with a program code for performing the method of claim 9, when the program code runs on a computer.

11. Decoder (300) for decoding an input codeword and for generating an output information word, the output information word having less bits than the input codeword, comprising:

a segmenter (310) for segmenting the input codeword into a plurality of ordered segments, a segment having information bits and redundancy bits;
an interleaver (320) for interleaving the information bits of the plurality of segments using a first interleaving rule to obtain a first interleaved version of the information bits and using a second interleaving rule to obtain a second interleaved version of the information bits, where the interleaver (320) is designed to generate the first interleaving rule as a predefined interleaving rule obtained by conducting a predefined number of sequenced intermediate sub-steps;
a zigzag decoder (33) for calculating the output information word based on the information bits, the first interleaved version of the information bits, the second interleaved version of the information bits and the redundancy bits; and
wherein the interleaver (320) is adapted to use as the second interleaving rule, an intermediated interleaving rule obtained by conducting a number of sub-steps of the predefined number of sequenced intermediate sub-steps, the number of sub-steps being lower than the predefined number of sequenced intermediate sub-steps by an omitted number of sub-steps, or an interleaving rule obtained by processing the intermediate interleaving rule in a different manner compared to the omitted number of sub-steps.

12. Method for decoding an input code word and for generating an output information word, the output information word having less bits than the input codeword, comprising the steps of:

segmenting the input codeword into a plurality of ordered segments, a segment having information bits and redundancy bits;

interleaving the information bits of the plurality of segments using a first interleaving rule to obtain a first interleaved version of the information bits, and using a second interleaving rule to obtain a second interleaved version of the information bits, where the interleaving is designed to generate the first interleaving rule as a predefined interleaving rule obtained by conducting a predefined number of sequenced intermediate sub-steps;

calculating the output information word based on the information bits, the first interleaved version of the information bits, the second interleaved version of the information bits and the redundancy bits based on a zigzag code, and

wherein the interleaving is adapted to use as the second interleaving rule an intermediate interleaving rule obtained by conducting a number of sub-steps of the predefined number of sequenced intermediate sub-steps, the number of sub-steps being lower than the predefined number of sequenced intermediate sub-steps by an omitted number of sub-steps, or an interleaving rule obtained by processing the intermediate interleaving rule in a different manner compared to the omitted number of sub-steps.

13. Computer program having a program code for performing a method of claim 12, when the program code runs on a computer.

**Patentansprüche**

1. Codierer (100) zum Erzeugen eines Ausgangscodeworts auf der Basis eines Eingangsinformationswortes, wobei das Eingangsinformationswort weniger Bits aufweist als das Ausgangscodewort, mit folgenden Merkmalen:

einem Segmentierer (110) zum Segmentieren des Eingangsinformationswortes in eine Mehrzahl von geordneten Segmenten, wobei die Segmente Bits aufweisen;

einen Zickzack-Codierkern (120) zum Berechnen eines Redundanzbits für ein aktuelles Segment, wobei ein Redundanzbit eines früheren Segments in der Reihenfolge verwendet wird, wenn das Redundanzbit für das aktuelle Segment berechnet wird;

eine Verschachtelungseinrichtung (130) zum Verschachteln der Bits der Mehrzahl von Segmenten unter Verwendung einer ersten Verschachtelungsregel, um eine erste verschachtelte Version zu erhalten, und zum Verschachteln der Bits der Mehrzahl von Segmenten unter Verwendung einer zweiten Verschachtelungsregel, um eine zweite verschachtelte Version zu erhalten, wobei die Verschachtelungseinrichtung (130) dahin gehend entworfen ist, die erste Verschachtelungsregel als eine vordefinierte Verschachtelungsregel zu erzeugen, die **dadurch** erhalten wird, dass eine vordefinierte Anzahl von sequenzierten Zwischenteilschritten durchgeführt wird; und

einen Ausgangscodewort-Konstruktor (140) zum Konstruieren des Ausgangscodeworts unter Verwendung des Eingangscodeworts oder einer verschachtelten Version desselben, eines Satzes von ersten Redundanzbits, die durch den Zickzack-Codierkern (120) erzeugt werden, der durch das Einganscodewort oder die erste verschachtelte Version gespeist wird, und eines Satzes von zweiten Redundanzbits, die durch den Zickzack-Codierkern (120) erzeugt werden, der durch die zweite verschachtelte Version gespeist wird,

wobei die Verschachtelungseinrichtung (130) dahin gehend angepasst ist, als zweite Verschachtelungsregel eine Zwischenverschachtelungsregel zu verwenden, die **dadurch** erhalten wird, dass eine Anzahl von Teilschritten der vordefinierten Anzahl von sequenzierten Zwischenteilschritten durchgeführt wird, wobei die Anzahl von Teilschritten um eine weggelassene Anzahl von Teilschritten geringer ist als die vordefinierte Anzahl von sequenzierten Zwischenteilschritten, oder eine Verschachtelungsregel zu verwenden, die **dadurch** erhalten wird, dass die Zwischenverschachtelungsregel im Vergleich zu der weggelassenen Anzahl von Teilschritten auf unterschiedliche Weise bearbeitet wird.

2. Codierer (100) gemäß Anspruch 1, bei dem die vordefinierte Verschachtelungsregel für einen Codiervorgang optimiert ist, der sich von dem durch den Zickzack-Codierkern (120) durchgeführten Codiervorgang unterscheidet.

3. Codierer (100) gemäß einem der Ansprüche 1 oder 2, bei dem die vordefinierte Verschachtelungsregel für einen verketteten Faltungscode oder Turbocode optimiert ist.

4. Codierer (100) gemäß einem der Ansprüche 1 bis 3, bei dem die vordefinierte Verschachtelungsregel folgende Teilschritte aufweist:

Erzeugen einer RxC-Eingangsmatrix, die R Zeilen aufweist, wobei jede Zeile einem Segment entspricht, das C Bits des Eingangsinformationswortes aufweist;
Austauschen von Zeilen der Eingangsmatrix;
Austauschen von Elementen innerhalb der ausgetauschten Zeilen der Eingangsmatrix;
spaltenweises Auslesen der Eingangsmatrix, die die ausgetauschten Zeilen und die ausgetauschten Elemente aufweist.

5. Codierer (100) gemäß einem der Ansprüche 1 bis 4, bei dem die vordefinierte Verschachtelungsregel der Verschachtelungsregel entspricht, die in der 3GPP-Spezifikation TS 25.212, Version 3.2.0, 2000-03, Verlautbarung 99, definiert ist.

6. Codierer (100) gemäß einem der Ansprüche 1 bis 5, bei dem die Verschachtelungseinrichtung (130) dahin gehend angepasst ist, die Zwischenverschachtelungsregel, die einer Matrixtransposition oder einem Zeilen- oder Spaltenaustausch einer Zwischenverschachtelungsmatrix aus der vordefinierten Verschachtelungsregel entspricht, zu bearbeiten.

7. Codierer (100) gemäß einem der Ansprüche 4 bis 6, bei dem eine Permutationsregel einer Kongruenz-Verschachtelungseinrichtung dazu verwendet wird, einen Austausch von Zeilen oder Spalten zu bestimmen.

8. Codierer (100) gemäß einem der Ansprüche 6 oder 7, bei dem die Bearbeitung ferner einen Auslesevorgang auf einer Matrix mit einer Ausleseregel umfasst, wobei die Ausleseregel derart ist, dass Zeilen oder Spalten ausgetauscht werden, Zeilen oder Spalten rückwärts ausgelesen werden, Zeilen oder Spalten in einer randomisierten Reihenfolge ausgelesen werden, oder Kombinationen derselben.

9. Verfahren zum Codieren durch Erzeugen eines Ausgangscodeworts auf der Basis eines Eingangsinformationswortes, wobei das Eingangsinformationswort weniger Bits aufweist als das Ausgangscodewort, mit folgenden Schritten:

Segmentieren des Eingangsinformationswortes in eine Mehrzahl von geordneten Segmenten, wobei die Segmente Bits aufweisen;
Berechnen eines Redundanzbits für ein aktuelles Segment auf der Basis eines Zickzack-Codes, wobei ein Redundanzbit eines früheren Segments in der Reihenfolge zum Berechnen des Redundanzbits für das aktuelle Segment verwendet wird;
Verschachteln der Bits der Mehrzahl von Segmenten unter Verwendung einer ersten Verschachtelungsregel, um eine erste verschachtelte Version zu erhalten, und zum Verschachteln der Bits der Mehrzahl von Segmenten unter Verwendung einer zweiten Verschachtelungsregel, um eine zweite verschachtelte Version zu erhalten, wobei das Verschachteln dahin gehend entworfen ist, die erste Verschachtelungsregel als eine vordefinierte Verschachtelungsregel zu erzeugen, die **dadurch** erhalten wird, dass eine vordefinierte Anzahl von sequenzierten Zwischenteilschritten durchgeführt wird;
Konstruieren des Ausgangscodeworts unter Verwendung des Eingangscodeworts oder einer verschachtelten Version desselben, eines Satzes von ersten Redundanzbits, die auf der Basis des Eingangscodeworts oder der ersten verschachtelten Version berechnet werden, und eines Satzes von Redundanzbits, die auf der Basis der zweiten verschachtelten Version berechnet werden;
wobei das Verschachteln als zweite Verschachtelungsregel eine Zwischenverschachtelungsregel verwendet, die **dadurch** erhalten wird, dass eine Anzahl von Teilschritten der vordefinierten Anzahl von sequenzierten Zwischenteilschritten durchgeführt wird, wobei die Anzahl von Teilschritten um eine weggelassene Anzahl von Teilschritten geringer ist als die vordefinierte Anzahl von sequenzierten Zwischenteilschritten, oder eine Verschachtelungsregel verwendet, die **dadurch** erhalten wird, dass die Zwischenverschachtelungsregel im Vergleich zu der weggelassenen Anzahl von Teilschritten auf unterschiedliche Weise bearbeitet wird.

10. Computerprogramm mit einem Programmcode zum Durchführen des Verfahrens gemäß Anspruch 9, wenn der Programmcode auf einem Computer läuft.

11. Decodierer (300) zum Decodieren eines Eingangscodeworts und zum Erzeugen eines Ausgangsinformationswortes, wobei das Ausgangsinformationswort weniger Bits aufweist als das Eingangscodewort, mit folgenden Merkmalen:

einem Segmentierer (310) zum Segmentieren des Eingangscodeworts in eine Mehrzahl von geordneten Segmenten, wobei ein Segment Informationsbits und Redundanzbits aufweist;
einer Verschachtelungseinrichtung (320) zum Verschachteln der Informationsbits der Mehrzahl von Segmenten unter Verwendung einer ersten Verschachtelungsregel, um eine erste verschachtelte Version der Informationsbits zu erhalten, und unter Verwendung einer zweiten Verschachtelungsregel, um eine zweite verschachtelte Version der Informationsbits zu erhalten, wobei die Verschachtelungseinrichtung (320) dahin gehend entworfen ist, die erste Verschachtelungsregel als vordefinierte Verschachtelungsregel zu erzeugen, die **dadurch** erhalten wird, dass eine vordefinierte Anzahl von sequenzierten Zwischenteilschritten durchgeführt wird;
einem Zickzack-Decodierer (33) zum Berechnen des Ausgangsinformationswortes auf der Basis der Informationsbits, der ersten verschachtelten Version der Informationsbits, der zweiten verschachtelten Version der Informationsbits und der Redundanzbits; und
wobei die Verschachtelungseinrichtung (130) dahin gehend angepasst ist, als zweite Verschachtelungsregel eine Zwischenverschachtelungsregel zu verwenden, die **dadurch** erhalten wird, dass eine Anzahl von Teilschritten der vordefinierten Anzahl von sequenzierten Zwischenteilschritten durchgeführt wird, wobei die Anzahl von Teilschritten um eine weggelassene Anzahl von Teilschritten geringer ist als die vordefinierte Anzahl von sequenzierten Zwischenteilschritten, oder eine Verschachtelungsregel zu verwenden, die **dadurch** erhalten wird, dass die Zwischenverschachtelungsregel im Vergleich zu der weggelassenen Anzahl von Teilschritten auf unterschiedliche Weise bearbeitet wird.

**12.** Verfahren zum Decodieren eines Eingangscodeworts und zum Erzeugen eines Ausgangsinformationswortes, wobei das Ausgangsinformationswort weniger Bits aufweist als das Eingangscodewort, mit folgenden Schritten:

Segmentieren des Eingangscodeworts in eine Mehrzahl von geordneten Segmenten, wobei ein Segment Informationsbits und Redundanzbits aufweist;
Verschachteln der Informationsbits der Mehrzahl von Segmenten unter Verwendung einer ersten Verschachtelungsregel, um eine erste verschachtelte Version der Informationsbits zu erhalten, und unter Verwendung einer zweiten Verschachtelungsregel, um eine zweite verschachtelte Version der Informationsbits zu erhalten, wobei das Verschachteln dahin gehend entworfen ist, die erste Verschachtelungsregel als vordefinierte Verschachtelungsregel zu erzeugen, die **dadurch** erhalten wird, dass eine vordefinierte Anzahl von sequenzierten Zwischenteilschritten durchgeführt wird;
Berechnen des Ausgangsinformationswortes auf der Basis der Informationsbits, der ersten verschachtelten Version der Informationsbits, der zweiten verschachtelten Version der Informationsbits und der Redundanzbits auf der Basis eines Zickzack-Codes, und
wobei das Verschachteln dahin gehend angepasst ist, als zweite Verschachtelungsregel eine Zwischenverschachtelungsregel zu verwenden, die **dadurch** erhalten wird, dass eine Anzahl von Teilschritten der vordefinierten Anzahl von sequenzierten Zwischenteilschritten durchgeführt wird, wobei die Anzahl von Teilschritten um eine weggelassene Anzahl von Teilschritten geringer ist als die vordefinierte Anzahl von sequenzierten Zwischenteilschritten, oder eine Verschachtelungsregel zu verwenden, die **dadurch** erhalten wird, dass die Zwischenverschachtelungsregel im Vergleich zu der weggelassenen Anzahl von Teilschritten auf unterschiedliche Weise bearbeitet wird.

**13.** Computerprogramm, das einen Programmcode zum Durchführen eines Verfahrens gemäß Anspruch 12 aufweist, wenn der Programmcode auf einem Computer läuft.

**Revendications**

**1.** Codeur (100) pour générer un mot de code de sortie sur base d'un mot d'information d'entrée, le mot d'information d'entrée présentant moins de bits que le mot de code de sortie, comprenant:

un segmenteur (110) destiné à segmenter le mot d'information d'entrée en une pluralité de segments ordonnés, les segments présentant des bits;
un noyau de codeur zigzag (120) destiné à calculer un bit de redondance pour un segment actuel, où un bit de redondance d'un segment antérieur dans l'ordre est utilisé lors du calcul du bit de redondance pour le segment actuel;
un entrelaceur (130) destiné à entrelacer les bits de la pluralité de segments à l'aide d'une première règle d'entrelacement, pour obtenir une première version entrelacée et à entrelacer les bits de la pluralité de segments à l'aide d'une deuxième règle d'entrelacement, pour obtenir une deuxième version entrelacée, où l'entrelaceur (130) est conçu pour générer la première règle d'entrelacement comme règle d'entrelacement prédéfinie obtenue en effectuant un nombre prédéfini de sous-étapes intermédiaires séquencées; et

un constructeur de mot de code de sortie (140) destiné à construire le mot de code de sortie à l'aide du mot de code d'entrée ou d'une version entrelacée de ce dernier, un ensemble de premiers bits de redondance généré par le noyau de codeur zigzag (120) alimenté par le mot de code d'entrée ou la première version entrelacée, et un ensemble de deuxièmes bits de redondance généré par le noyau de codeur zigzag (120) alimenté par la deuxième version entrelacée,

dans lequel l'entrelaceur (130) est adapté pour utiliser, comme deuxième règle d'entrelacement, une règle d'entrelacement intermédiaire obtenue en effectuant un certain nombre de sous-étapes du nombre prédéfini de sous-étapes intermédiaires séquencées, le nombre de sous-étapes étant inférieur au nombre prédéfini de sous-étapes intermédiaires séquencées d'un nombre omis de sous-étapes, ou une règle d'entrelacement obtenue en traitant la règle d'entrelacement intermédiaire de manière différente, comparé au nombre omis de sous-étapes.

2. Codeur (100) selon la revendication 1, dans lequel la règle d'entrelacement prédéfinie est optimisée pour une opération de codage différente de l'opération de codage effectuée par le noyau de codeur zigzag (120).

3. Codeur (100) selon l'une des revendications 1 ou 2, dans lequel la règle d'entrelacement prédéfinie est optimisée pour un code convolutionnel où code turbo concaténé.

4. Codeur (100) selon l'une des revendications 1 à 3, dans lequel la règle d'entrelacement prédéfinie comprend les sous-étapes consistant à:

générer une matrice d'entrée R x C, présentant R rangées, chaque rangée correspondant à un segment présent C bits du mot d'information d'entrée;
échanger les rangées de la matrice d'entrée;
échanger les éléments dans les rangées échangées de la matrice d'entrée;
lire la matrice d'entrée présentant les rangées échangées et les éléments échangés par colonne.

5. Codeur (100) selon l'une des revendications 1 à 4, dans lequel la règle d'entrelacement prédéfinie correspond à la règle d'entrelacement définie dans la spécification 3GPP TS 25.212, version 3.2.0, 2000-03, édition 99.

6. Codeur (100) selon l'une des revendications 1 à 5, dans lequel l'entrelaceur (130) est adapté de manière à traiter la règle d'entrelacement intermédiaire correspondant à une transposition de matrice ou un échange de rangées ou de colonnes d'une matrice d'entrelacement intermédiaire à partir de la règle d'entrelacement prédéfinie.

7. Codeur (100) selon l'une des revendications 4 à 6, dans lequel une règle de permutation d'un entrelaceur congruentiel est utilisée pour déterminer un échange de rangées ou colonnes.

8. Codeur (100) selon l'une des revendications 6 ou 7, dans lequel le traitement comprend par ailleurs une opération de lecture sur une matrice par une règle de lecture, la règle de lecture étant telle que les rangées ou colonnes sont échangées, les rangées ou colonnes sont lues en arrière, les rangées ou colonnes sont lues dans un ordre aléatoire, ou des combinaisons de ces dernières.

9. Procédé pour générer un mot de code de sortie sur base d'un mot d'information d'entrée, le mot d'information d'entrée présentant moins de bits que le mot de code de sortie, comprenant les étapes consistant à:

segmenter le mot d'information d'entrée en une pluralité de segments ordonnés, les segments présentant des bits;
calculer un bit de redondance pour un segment actuel sur base d'un code zigzag, où un bit de redondance d'un segment antérieur dans l'ordre est utilisé pour calculer le bit de redondance pour le segment actuel;
entrelacer les bits de la pluralité de segments à l'aide d'une première règle d'entrelacement, pour obtenir une première version entrelacée et entrelacer les bits de la pluralité de segments à l'aide d'une deuxième règle d'entrelacement, pour obtenir une deuxième version entrelacée, où l'entrelacement est conçu pour générer la première règle d'entrelacement comme règle d'entrelacement prédéfinie obtenue en effectuant un nombre prédéfini de sous-étapes intermédiaires séquencées; et

construire le mot de code de sortie à l'aide du mot de code d'entrée ou d'une version entrelacée de ce dernier, un ensemble de premiers bits de redondance calculé sur base du mot de code d'entrée ou de la première version entrelacée, et un ensemble de deuxièmes bits de redondance calculés sur base de la deuxième version entrelacée,

dans lequel l'entrelacement utilise, comme deuxième règle d'entrelacement, une règle d'entrelacement intermédiaire obtenue en effectuant un certain nombre de sous-étapes du nombre prédéfini de sous-étapes intermédiaires séquencées, le nombre de sous-étapes étant inférieur au nombre prédéfini de sous-étapes intermédiaires séquencées d'un nombre omis de sous-étapes, ou une règle d'entrelacement obtenue en traitant la règle d'entrelacement intermédiaire de manière différente, comparé au nombre omis de sous-étapes.

10. Programme d'ordinateur avec un code de programme pour réaliser le procédé selon la revendication 9 lorsque le code de programme est exécuté sur un ordinateur.

11. Décodeur (300) pour décoder un mot de code d'entrée et pour générer un mot d'information de sortie, le mot d'information de sortie présentant moins de bits que le mot de code d'entrée, comprenant:

un segmenteur (310) destiné à segmenter le mot de code d'entrée en une pluralité de segments ordonnés, un segment présentant des bits d'information et des bits de redondance;
un entrelaceur (320) destiné à entrelacer les bits d'information de la pluralité de segments à l'aide d'une première règle d'entrelacement, pour obtenir une première version entrelacée des bits d'information et à l'aide d'une deuxième règle d'entrelacement, pour obtenir une deuxième version entrelacée des bits d'information, où l'entrelaceur (320) est conçu pour générer la première règle d'entrelacement comme règle d'entrelacement prédéfinie obtenue en effectuant un nombre prédéfini de sous-étapes intermédiaires séquencées;
un décodeur zigzag (33) destiné à calculer le mot d'information de sortie sur base des bits d'information, de la première version entrelacée des bits d'information, de la deuxième version entrelacée des bits d'information et des bits de redondance; et
dans lequel l'entrelaceur (320) est adapté pour utiliser, comme deuxième règle d'entrelacement, une règle d'entrelacement intermédiaire obtenue en effectuant un certain nombre de sous-étapes du nombre prédéfini de sous-étapes intermédiaires séquencées, le nombre de sous-étapes étant inférieur au nombre prédéfini de sous-étapes intermédiaires séquencées d'un nombre omis de sous-étapes, ou une règle d'entrelacement obtenue en traitant la règle d'entrelacement intermédiaire de manière différente, comparé au nombre omis de sous-étapes.

12. Procédé pour décoder un mode de code d'entrée et générer un mot d'information de sortie, le mot d'information de sortie présentant moins de bits que le mot de code d'entrée, comprenant les étapes consistant à:

segmenter le mot de code d'entrée en une pluralité de segments ordonnés, un segment présentant des bits d'information et des bits de redondance;
entrelacer les bits d'information de la pluralité de segments à l'aide d'une première règle d'entrelacement, pour obtenir une première version entrelacée des bits d'information, et à l'aide d'une deuxième règle d'entrelacement, pour obtenir une deuxième version entrelacée des bits d'information, où l'entrelacement est conçu pour générer la première règle d'entrelacement comme règle d'entrelacement prédéfinie obtenue en effectuant un nombre prédéfini de sous-étapes intermédiaires séquencées;
calculer le mot d'information de sortie sur base des bits d'information, de la première version entrelacée des bits d'information, de la deuxième version entrelacée des bits d'information et des bits de redondance sur base d'un code zigzag, et
dans lequel l'entrelacement est adapté pour utiliser, comme deuxième règle d'entrelacement, une règle d'entrelacement intermédiaire obtenue en effectuant un certain nombre de sous-étapes du nombre prédéfini de sous-étapes intermédiaires séquencées, le nombre de sous-étapes étant inférieur au nombre prédéfini de sous-étapes intermédiaires séquencées d'un nombre omis de sous-étapes, ou une règle d'entrelacement obtenue en traitant la règle d'entrelacement intermédiaire de manière différente, comparé au nombre omis de sous-étapes.

13. Programme d'ordinateur ayant un code de programme pour réaliser un procédé selon la revendication 12 lorsque le code de programme est exécuté sur un ordinateur.

## FIG 1

## FIG 2

## FIG 3

310     330     320

Segmenter → segments

input

Zig Zag Decoder

Interleaver

first interleaved version

second interleaved version

output

300

## FIG 4

C

$d_1$ | $d_2$ | ... | $d_{C-2}$ | $d_{C-1}$ | $d_C$

$d_{C+1}$ | $d_{C+2}$ | ... | $d_{2C-2}$ | $d_{2C-1}$ | $d_{2C}$

$d_{2C+1}$ | $d_{2C+2}$ | ... | $d_{3C-2}$ | $d_{3C-1}$ | $d_{3C}$

... | ... | ... | ... | ... | ...

$d_{(R-1)C+1}$ | $d_{(R-1)C+2}$ | ... | $d_{RC-2}$ | $d_{RC-1}$ | $d_{RC}$

R

R x C matrix

# FIG 5a

# FIG 5b

# FIG 5c

# FIG 5d

FIG 5e

FIG 5f

FIG 5g

FIG 5h

FIG 6a

FIG 6b

FIG 7a

FIG 7b

## FIG 8

| | | read out | | | |
|---|---|---|---|---|---|
| ②↑ | | | ↑① | | |

| $d_1'$ | $d_2'$ | ... | $d_{C-2}'$ | $d_{C-1}'$ | $d_C'$ |
|---|---|---|---|---|---|
| $d_{C+1}'$ | $d_{C+2}'$ | ... | $d_{2C-2}'$ | $d_{2C-1}'$ | $d_{2C}'$ |
| $d_{2C+1}'$ | $d_{2C+2}'$ | ... | $d_{3C-2}'$ | $d_{3C-1}'$ | $d_{3C}'$ |
| ... | ... | ... | ... | ... | ... |
| $d_{(R-1)C+1}'$ | $d_{(R-1)C+2}'$ | ... | $d_{RC-2}'$ | $d_{RC-1}'$ | $d_{RC}'$ |

$\Pi_{c,k}(2)=2$
start at row 2 upwards

$\Pi_{c,k}(1)=C-2$
start at row 3 downwards

## FIG 9

# FIG 10
(State of the art)

$$d_{1,1} \oplus d_{1,2} \oplus \ldots \oplus d_{1,J} = p_1$$

$$\oplus$$

$$d_{2,1} \oplus d_{2,2} \oplus \ldots \oplus d_{2,J} = p_2$$

$$\oplus$$

$$\vdots$$

$$\oplus$$

$$d_{I-1,1} \oplus d_{I-1,2} \oplus \ldots \oplus d_{I-1,J} = p_{I-1}$$

$$\oplus$$

$$d_{I,1} \oplus d_{I,2} \oplus \ldots \oplus d_{I,J} = p_I$$

# FIG 11
(State of the art)

# FIG 12
(State of the art)

$$0 \oplus 0 \oplus 0 \oplus 0 = 0$$

$$\mathring{A}$$

$$0 \oplus 1 \oplus 1 \oplus 0 = 0$$

$$\oplus \qquad \vdots$$

$$\vdots \qquad 0$$

$$\oplus$$

$$0 \oplus 0 \oplus 0 \oplus 0 = 0$$

$$w_H = d_{min} = 2$$

# FIG 13
(State of the art)

$$0 \oplus 1 \oplus 0 \oplus 0 = 1$$

$$\oplus$$

$$0 \oplus 0 \oplus 1 \oplus 0 = 0$$

$$\oplus \qquad \vdots$$

$$\vdots \qquad 0$$

$$\oplus$$

$$0 \oplus 0 \oplus 0 \oplus 0 = 0$$

$$w_H = 3$$

# FIG 14
(State of the art)

$d_{i,j}$

$d_{i,j}$

$\cdots$

code 1 $\rightarrow p_{1,i}$

$\Pi_1$ code 2 $\rightarrow p_{2,i}$

$\Pi_{K-1}$ code $K$ $\rightarrow p_{K,i}$

# FIG 15
(State of the art)

BER

good randomization

avoid worst case
patterns

SNR

## FIG 16
(State of the art)

## FIG 17
(State of the art)

28

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1441448 A2

**Non-patent literature cited in the description**

- **L. Ping ; X. Huang ; N. Phamdo.** Zigzag codes and concatenated zigzag codes. *IEEE Transactions on Information Theory,* February 2001, vol. 47, 800-807
- **S.-N. Hong ; D.-J. Shin.** Construction and analysis of rate compatible punctured concatenated zigzag codes. *International Symposium on Information Theory (ISIT),* September 2005, 840-844
- **S.-N. Hong ; D.-J. Shin.** Optimal rate-compatible punctured concatenated zigzag codes. *International Conference on Communications (ICC),* May 2005, 627-631
- **S.-N. Hong ; D.-J. Shin.** Design of irregular concatenated zigzag codes. *International Symposium on Information Theory (ISIT),* September 2005, 1363-1366
- **L. Ping ; S. Chan ; K. Yeung.** Iterative decoding of multidimensional concatenated single parity check codes. *International Conference on Communications (ICC),* June 1998, 131-135
- **X. Wu ; Y. Xue ; H. Xiang.** On concatenated zigzag codes and their decoding schemes. *IEEE Communications Letters,* January 2004, vol. 8, 54-56
- **N. Nefedov.** Multi-dimensional zigzag codes for high data rate transmission. *3rd International Symposium on Turbo Codes and Related Topics,* September 2003, 215-218
- **N. Nefedov.** data rate transmission. *14th International Symposium on Personal, Indoor and Mobile Radio Communications,* September 2003, 1868-1872
- **L. Bahl ; J. Cocke ; F. Jelinek ; J. Raviv.** Optimal decoding of linear codes for minimizing symbol error rate. *IEEE Transactions on Information Theory,* March 1974, vol. IT-20, 284-287
- **J. Hagenauer ; E. Offer ; L. Papke.** Iterative decoding of binary block and convolutional codes. *IEEE Transactions on Information Theory,* March 1996, vol. IT-42, 425-429
- **N. Nefedov.** Evaluation of low complexity concatenated codes for high data rate transmission. *14th International Symposium on Personal, Indoor and Mobile Radio Communications,* September 2003, 1868-1872

- **A. Tarable ; G. Montorsi ; S. Benedetto.** Analysis and design of interleavers for iterative multi-user receivers in coded CDMA systems. *IEEE Transactions on Information Theory,* May 2005, vol. 51, 1650-1666
- **S. Brück ; U. Sorger ; S. Gligorevic ; N. Stolte.** Interleaving for outer convolutional codes in DS-CDMA systems. *IEEE Transactions on Communications,* July 2000, vol. 48, 1100-1107
- **K. Kusume ; G. Bauch.** Cyclically shifted multiple interleavers. *Globecom, IEEE,* November 2006
- **K. Kusume ; G. Bauch.** Some aspects of interleave division multiple access in ad hoc networks. *4th International Symposium on Turbo Codes and Related Topics,* April 2006
- **A. Barbulescu ; S. Pietrobon.** Interleaver design for three dimensional turbo codes. *IEEE International Symposium on Information Theory,* September 1995, 37
- **N. Ehtiati ; M. Soleymani ; H. Sadjadpour.** Interleaver design for multiple turbo codes. *Canadian Conference on Electrical and Computer Engineering,* May 2003, 1605-1607
- **N. Ehtiati ; M. Soleymani ; H. Sadjadpour.** Joint interleaver design for multiple turbo codes. *IEEE Vehicular Technology Conference (VTC Fall),* September 2004, 2302-2306
- **A. Tarable ; G. Montorsi ; S. Benedetto.** Analysis and design of interleavers for iterative multiuser receivers in coded CDMA systems. *IEEE Transactions on Information Theory,* May 2005, vol. 51, 1650-1666
- **S. Crozier ; J. Lodge ; P. Guinand ; A. Hunt.** performance of turbo-codes with relative prime and golden interleaving strategies. *International Mobile Satellite Conference,* 1999, 268-275
- **D. Divsalar ; F. Pollara.** Multiple turbo codes for deep-space communications. *TDA Progress Report,* May 1995, 42-121
- **T. Sohdoh ; N. Nishinaga ; Y. Iwadare.** The new interleaver design of turbo codes for error floor improvement. *20th Symposium on Information Theory and its Applications,* December 1997, 13-16